Europäisches Patentamt

European Patent Office

Office européen des brevets

(19)

(11) **EP 0 635 585 B1**

(12)

# FASCICULE DE BREVET EUROPEEN

(45) Date de publication et mention
de la délivrance du brevet:
**14.05.1997 Bulletin 1997/20**

(51) Int Cl.⁶: **C23C 18/18**, C04B 41/88

(21) Numéro de dépôt: **94870124.8**

(22) Date de dépôt: **19.07.1994**

(54) **Procédé de production d'une couche métallique épaisse et fortement adhérente sur un substrat de nitrure d'aluminium frittée et produit métallisé ainsi obtenu**

Verfahren zur Herstellung einer dick und stark haftenden Metallschicht auf gesintertes Aluminiumnitrid sowie auf diese Weise hergestelltes metallisiertes Produkt

Process for producing a thick and strongly adhering metallic layer on sintered aluminium nitride and metallised product thus obtained

(84) Etats contractants désignés:
**BE CH DE ES FR GB IT LI NL**
Etats d'extension désignés:
**SI**

(30) Priorité: **23.07.1993 BE 9300772**

(43) Date de publication de la demande:
**25.01.1995 Bulletin 1995/04**

(73) Titulaire: **Laude, Lucien Diégo**
**F-59330 Hautmont (FR)**

(72) Inventeur: **Laude, Lucien Diégo**
**F-59330 Hautmont (FR)**

(74) Mandataire: **Schmitz, Yvon et al**
**GEVERS Patents,**
**Brussels Airport Business Park,**
**Holidaystraat 5**
**1831 Diegem (BE)**

(56) Documents cités:
**EP-A- 0 501 095**

- **ADVANCED MATERIALS FOR OPTICS AND ELECTRONICS, vol.2, no.4, Juillet 1993, GB pages 183 - 189 SHAFEEV 'laser activation and metallisation of oxide ceramics'**

## Description

La présente invention est relative à un procédé de métallisation en trois étapes qui permet de produire une couche métallique épaisse très adhérente sur un substrat de nitrure d'aluminium fritté.

Les matériaux céramiques utilisés dans les systèmes électriques ou électroniques, comme support de circuits intégrés ou d'éléments actifs (par exemple : résistances, capacités) pour former des circuits hybrides, sont des isolants électriques qui présentent en général la particularité d'être aussi des isolants thermiques (alumines frittées de divers types), avec une conductibilité thermique très faible mais aussi une capacité thermique élevée. Ces matériaux peuvent donc accumuler de la chaleur tout en assurant leur fonction première d'isolation électrique. La conjugaison de ces propriétés (électrique et thermique) ne présente pas d'inconvénient lorsque la charge thermique demeure faible lors du fonctionnement du système électronique (comprenant des circuits intégrés) monté sur la céramique. C'est par exemple le cas lorsque les pistes métalliques qui interconnectent les éléments actifs d'un circuit hybride sont parcourues par des courants électriques faibles en régime permanent, ou élevés en régime transitoire. L'accroissement de température des pistes d'interconnexion, qui résulte de leur résistance électrique, demeure faible. Il peut donc être accommodé par le substrat qui joue alors le rôle de volant thermique de l'ensemble formé par le circuit hybride et son substrat.

Lorsque les courants électriques deviennent élevés (supérieurs à 1A) en régime permanent, la faible conductibilité thermique d'un substrat d'alumine ne permet pas à celui-ci de drainer la chaleur générée dans le circuit hybride. Par suite, la température du substrat d'alumine frittée croît continuement lors de ce fonctionnement, ainsi que celle de toute l'électronique montée sur le substrat. La conséquence de cet échauffement pour le fonctionnement des circuits intégrés est très grave puisqu'il conduit à l'interruption de leur fonctionnement, en particulier à des températures supérieures à 80°C.

Ce comportement des substrats d'alumine frittée est entièrement dû à la faible conductibilité thermique de l'alumine frittée. Pour tous les systèmes électroniques qui doivent fonctionner à des températures élevées, il est donc impératif d'utiliser des substrats permettant à la fois l'isolation électrique et le refroidissement systématique et efficace des circuits électroniques qui y sont montés, c'est-à-dire des substrats constitués d'un matériau qui est à la fois un isolant électrique et un conducteur thermique. Le nitrure d'aluminium (AlN) fritté est un de ces matériaux. L'utilisation de ce matériau est toutefois asservie à la résolution de problèmes d'interface entre celui-ci et le métal des pistes métalliques d'interconnexion des circuits hybrides ou de tous autres systèmes électroniques.

Dans les circuits de puissance, l'intensité des courants continus nécessaires est relativement élevée (supérieure à 20A) et le transport de tels courants nécessite des pistes métalliques d'épaisseur supérieure à 50 micromètres et pouvant atteindre 250 micromètres. Par ailleurs, comme on l'a précisé plus haut, la chaleur générée par le transport d'électricité à de telles puissances est importante. Il est donc approprié de réaliser de tels circuits de puissance sur substrat d'AlN. Cependant, le métal des pistes d'interconnexion et l'AlN ont des coefficients de dilatation très différents. Lors de l'échauffement, une contrainte mécanique se développe à l'interface entre métal et AlN. Celle-ci ne peut être compensée que par une adhérence excellente de la piste métallique sur l'AlN, quelle que soit l'épaisseur de celle-ci et cette nécessité est d'autant plus critique que l'épaisseur est grande. Autrement dit, pour les applications dans lesquelles l'AlN est indispensable (courants élevés, charge thermique importante), il est absolument nécessaire d'accroître suffisamment l'adhérence des pistes métalliques épaisses sur un substrat d'AlN avant d'envisager l'exploitation de tels substrats.

La difficulté de produire des films métalliques épais (épaisseur supérieure à 50 micromètres) et très adhérents sur substrat d'AlN a, jusqu'à maintenant, limité l'exploitation des propriétés particulières de l'AlN (isolation électrique et conductibilité thermique). En effet, les méthodes physiques (évaporation sous vide, dépôt par plasma ou pulvérisation) comme les méthodes chimiques (par exemple, décomposition d'organo-métalliques suivie d'un dépôt par voie autocatalytique) permettent de fixer une couche métallique sur tout substrat sans jamais modifier la structure superficielle de ce substrat. L'adhérence obtenue ne dépasse pas le niveau du test de pelage à l'aide d'un film adhésif autocollant. L'amélioration de l'adhérence initiale peut alors être obtenue par un traitement thermique de la pièce métallisée maintenue à haute température (600°C) pendant plusieurs heures, c'est-à-dire par la diffusion non sélective et non réactive des atomes métalliques le long des joints des grains d'AlN qui constituent le substrat fritté. L'adhérence obtenue ainsi est de l'ordre de 10 MPa pour des films d'épaisseur égale à 50 micromètres. Par ailleurs, ces techniques comportent en général une série de plusieurs (6 à 8) étapes de traitement et ont une spécificité limitée (définition des limites des zones métallisées à plus de 50 micromètres). Pour les épaisseurs supérieures à 100 micromètres, il est fait recours à la technique dite du "bondage" qui consiste à préalablement oxyder une des deux faces d'une plaque de cuivre (d'épaisseur de 200 micromètres par exemple), puis à appliquer sous pression la face oxydée sur la surface d'une plaque d'AlN portée à 900°C, sous atmosphère d'azote, pendant plusieurs heures. La jonction entre les deux pièces opère alors par transfert d'oxygène de l'oxyde vers l'AlN et formation d'un complexe chimique assurant l'interface. Indépendamment du fait que cette technique de "bondage" ne peut s'appliquer à des métallisations spécifiques (surfaces de faible étendue ou de géométrie compliquée), elle ne permet pas d'obtenir un contact intégral entre le substrat et la plaque de métal rapportée, en particulier à cause de la planéité imparfaite du substrat telle qu'obtenue lors de sa fabrication.

Indépendamment de la méthode de métallisation, les substrats d'AlN fritté sont fabriqués à partir de poudres d'AlN synthétisées par diverses techniques connues de l'art. Chaque grain d'AlN a une taille voisine de quelques micromètres. En général, ces poudres contiennent divers types d'impuretés dont les plus importantes sont : l'oxygène, en concentration pouvant atteindre 3 % du volume, et le carbone. Cependant, une analyse par spectroscopie Auger de la surface des grains indique que ces impuretés sont concentrées en fait à la surface des grains. La concentration effective de l'oxygène peut donc atteindre 10 % de la surface des grains. Ces impuretés interviennent lors de tout traitement (thermique ou non) des substrats d'AlN fritté.

Les diverses techniques classiques de métallisation décrites plus haut ont atteint leurs limites de développement sur AlN fritté sans permettre d'atteindre des adhérences suffisantes, en particulier pour des films très épais d'épaisseur supérieure à 50 micromètres, pour lesquels l'adhérence devrait être supérieure à 10 MPa. D'autre part, ces techniques classiques sont très lourdes et onéreuses sans permettre une flexibilité suffisante d'application. L'AlN se trouve ainsi pénalisé et ne peut être utilisé au mieux de ses capacités.

Le procédé de métallisation décrit dans la présente invention surpasse ces limitations. Il permet d'améliorer très sensiblement l'adhérence des films métalliques épais sur substrat d'AlN fritté. Il offre par ailleurs une grande simplicité de réalisation, associée à une bonne fiabilité (taux d'échec inférieur à 10 %).

Le procédé qui fait l'objet de cette invention comporte trois étapes qui sont successivement :

a) l'irradiation de la pièce d'AlN par le faisceau d'un laser excimère d'une longueur d'onde comprise entre 190 et 350 nanomêtres et d'une densité d'énergie de 300 à 800 mJ/cm$^2$;
b) l'immersion de la pièce d'AlN irradiée dans une solution autocatalytique contenant des ions métalliques;
c) le traitement à chaud à une température de 400 à 500°C pendant des périodes de temps comprises entre 15 et 30 secondes de la pièce d'AlN traitée successivement suivant les étapes a) et b).

L'objet de chacune de ces trois étapes est le suivant :

## Première étape

L'irradiation du substrat d'AlN est réalisée avec un laser excimère qui émet dans l'ultraviolet et pendant des temps très courts (20 à 30 nanosecondes) des photons d'une énergie de 5,0 eV, correspondant à une longueur d'onde de 248 nanomètres. Le faisceau laser a une section rectangulaire (typiquement 8 x 25 mm) qui permet d'irradier soit à poste fixe, au travers d'un masque, des surfaces restreintes du substrat, soit par balayage sur un substrat se déplaçant dans un plan perpendiculaire à l'axe du faisceau laser.

A la longueur d'onde du laser, l'AlN absorbe le rayonnement. En fonction de l'intensité du rayonnement, donc de l'énergie contenue dans le faisceau laser, le nombre de photons présents dans ce faisceau et qui sont absorbés par le matériau AlN peut être suffisant pour induire plusieurs types de transformations dans le matériau irradié, sur la profondeur de pénétration du rayonnement qui est, dans le cas de l'AlN, de l'ordre de 3 à 5 micromètres à 248 nm de longueur d'onde.

A faible densité d'énergie (inférieure à 300 mJ/cm$^2$), une proportion faible des liaisons interatomiques entre atomes d'aluminium (Al) et atomes d'azote (N) qui sont présents dans la partie du substrat pénétrée par le rayonnement sont dissociées. Les atomes d'azote libérés s'associent avec les atomes d'oxygène présents à la surface des grains d'AlN irradiés et forment des monomères NO métastables. Ceux-ci perdurent pendant un temps variable (jusqu'à 60 minutes) avant de se dissocier. Les mêmes atomes d'azote se recombinent alors avec les atomes d'aluminium célibataires et le système d'atomes retrouve son équilibre antérieur à l'irradiation.

A plus forte densité d'énergie (entre 300 et 800 mJ/cm$^2$), les liaisons Al-N brisées pendant la durée de l'irradiation, par absorption de photons, sont plus nombreuses ainsi que le nombre de monomères NO formés. La distance moyenne entre ces monomères métastables qui coexistent dans le matériau au voisinage de sa surface est plus faible que précédemment. Certains de ces monomères s'associent pour former des couples de monomères beaucoup plus stables que les monomères euxmêmes. Les couples peuvent alors s'extraire de l'attraction des autres éléments atomiques du système et se libérer pour former une phase gazeuse (plusieurs oxydes d'azote existent en phase gazeuse, en particulier NO, $NO_2$ et $N_2O_4$). Cette évolution irréversible du système sous l'action du rayonnement à ces densités d'énergie entraîne la vaporisation du substrat, c'est-à-dire l'émission et la perte d'atomes d'azote par le substrat d'AlN. Les atomes d'aluminium célibataires restent au voisinage de la surface du substrat. Leur accumulation sur cette surface se matérialise par l'apparition d'une couche métallique au fur et à mesure que des irradiations successives sont réalisées en se superposant sur le substrat.

A des densités d'énergie supérieures à 800 mJ/cm$^2$, les atomes d'aluminium célibataires accumulés à la surface du substrat forment écran pour ce substrat au rayonnement qui ne peut plus interagir avec les grains d'AlN sous-jacents. Le processus d'émission de monomères NO est interrompu. Par contre, le couplage entre les atomes d'aluminium et le rayonnement devient important et conduit à la vaporisation de l'aluminium. La surface du matériau retrouve sa composition originale et le processus se reproduit.

Dans le régime d'irradiation intermédiaire ci-dessus, une métallisation est obtenue par l'apparente "réduction" de l'AlN :

$$AlN \rightarrow Al + N.$$

La première étape du procédé décrit dans cette invention permet donc cette métallisation. L'épaisseur de la couche métallique d'aluminium est variable. Elle peut atteindre typiquement 0,5 micromètre. Toutefois, son adhérence est relativement faible : 200 KPa tel qu'évalué au test d'arrachement ("pull-test"). Cette valeur est nettement trop faible pour permettre l'utilisation de ce type d'irradiation en vue de fabriquer des pistes métalliques, sur un substrat d'AlN, qui répondraient aux critères d'adhérence nécessaires.

### Deuxième Etape

Après irradiation, le substrat d'AlN est immergé dans un bain autocatalytique contenant des ions métalliques (par exemple, $Ni^{2+}$) et dont la composition est connue de l'art. Ces ions se déposent alors sélectivement et uniquement sur les zones de la surface du substrat recouvertes d'aluminium. L'épaisseur de cette nouvelle couche métallique (de nickel, par exemple) dépend de la composition du bain autocatalytique et du temps d'immersion. Typiquement, un film de 20 micromètres d'épaisseur de métal peut être déposé par heure d'immersion. C'est ainsi que la couche métallique obtenue par électrolyse a avantageusement une épaisseur totale comprise entre 30 et 250 micromètres. L'adhérence de ce film demeure identique à celle de la couche d'aluminium obtenue au cours de la première étape décrite plus haut. Pour la suite du déroulement du procédé, la couche déposée lors de cette étape peut être limitée à quelques micromètres d'épaisseur. Le dépôt autocatalytique, par exemple de 5 micromètres d'épaisseur, peut être suivi avantageusement d'un dépôt électrolytique avec polarisation du même métal ou non que celui déposé par autocatalyse ou d'un métal différent, d'une épaisseur comprise entre 10 et 250 micromètres.

### Troisième Etape

Le substrat d'AlN (habituellement plan) est maintenant équipé sur une de ses faces d'un film métallique épais constitué par exemple de nickel. Ce film est superposé au film d'aluminium tel qu'obtenu lors de la première étape du procédé. Les deux films ont exactement la même géométrie, telle qu'elle a été imposée par la méthode d'irradiation (à poste fixe au travers d'un masque, ou par balayage). Le substrat partiellement métallisé est alors porté à une température voisine de 400°C, mais pouvant atteindre 500°C sans affecter l'efficacité du procédé, pendant 15 à 30 secondes. Ce traitement thermique est réalisé en présentant le substrat plan d'AlN en regard et au contact d'une flamme produite par un brûleur à gaz ou par toute autre source de chaleur du même type, la face du substrat qui est tournée vers la flamme étant celle ne contenant pas la couche métallique préparée précédemment. Sous l'action de la chaleur et grâce à la très grande conductibilité thermique du substrat, la couche métallique fond instantanément à l'interface d'avec le substrat. Le retrait de la flamme provoque le refroidissement du substrat et de la couche métallique. La température de l'ensemble décroît à partir de la face qui était tournée vers la flamme, et qui, maintenant, est à plus basse température que la face du substrat qui contient la couche métallique. Les atomes métalliques au contact du substrat sont alors amenés à diffuser vers l'intérieur de celui-ci jusqu'à ce que la température de l'ensemble redevienne homogène. La charge thermique introduite dans le substrat suivant ce mode de chauffage est réduite. Par suite, le gradient de température initial lors de la phase de refroidissement est très fortement atténué au bout de quelques dix secondes après le retrait de la flamme. Au cours de cette période de temps, les atomes métalliques pénètrent dans le substrat sur une distance variable qui ne devrait pas excéder 0,5 micromètre, leur permettant de diffuser sur toute la surface des grains d'AlN présents à la surface du substrat. Ce processus assure un ancrage relativement sûr du film métallique qui se traduit par un accroissement considérable de l'adhérence de la couche métallique comme on le verra dans les exemples cités dans la suite du texte. Les techniques classiques de diffusion par voie thermique sont habituellement réalisées, dans un four par exemple, pendant des périodes de temps de l'ordre de plusieurs heures, c'est-à-dire mille fois plus longues que celles utilisées dans le procédé décrit dans l'invention. Ces techniques classiques sont absolument inadaptées au cas de l'AlN du fait de sa très haute conductibilité thermique.

### **Exemple 1**

Une plaque d'AlN de 0,6 mm d'épaisseur est irradiée par le faisceau émis par un laser excimère à 248 nm (source KrF), avec une densité d'énergie de 600 mJ/$cm^2$. L'émission est répétée à une fréquence de 1 Hz et, simultanément, la plaque d'AlN est déplacée dans un plan perpendiculaire à l'axe du faisceau avec une vitesse de 0,4 mm/sec. Après irradiation, la plaque comporte une piste métallisée d'aluminium. Elle est alors immergée pendant 90 minutes dans une solution autocatalytique contenant des ions de cuivre et maintenue à 40°C. Après immersion, une couche de cuivre d'une épaisseur de 4 micromètres est obtenue sur la zone préalablement irradiée. La plaque est ensuite soumise à un chauffage au moyen d'un brûleur à gaz permettant d'atteindre une température de 450 à 550°C pendant 15 secondes.

Un fil de cuivre (diamètre 0,8 mm) est ensuite brasé verticalement sur la surface métallisée pour permettre d'évaluer la force d'arrachement de ce fil. En appliquant une force étalonnée sur ce fil, l'arrachement du fil est obtenu à 30 MPa.

La même préparation d'un substrat identique par irradiation laser, puis immersion dans le même bain autocatalytique, mais sans traitement thermique correspondant à la troisième étape du procédé décrit dans cette invention, est ensuite réalisée. L'évaluation de la force d'arrachement d'un fil de cuivre est mesurée comme précédemment. L'arrachement est alors obtenu à 0,3 MPa. La troisième étape du procédé permet ainsi d'améliorer d'un facteur 100 l'adhérence du film de cuivre sur le substrat d'AlN.

## Exemple 2

Une plaque d'AlN de 0,6 mm d'épaisseur est, irradiée identiquement à l'Exemple 1, puis immergée dans une solution autocatalytique contenant des ions de nickel $Ni^{2+}$. Après immersion pendant 15 minutes, une couche de nickel d'épaisseur de 4 micromètres est obtenue sur la surface préalablement irradiée. Un contact électrique est réalisé sur cette couche de nickel. La plaque métallisée est alors plongée dans une solution électrolytique de nickel dans lequel elle est polarisée négativement vis-à-vis d'une électrode portée à un potentiel positif de quelques volts. Un dépôt électrolytique de nickel se développe alors sur la couche précédemment obtenue par voie autocatalytique sur la plaque d'AlN. Après 90 minutes d'immersion dans la solution électrolytique, la plaque est alors recouverte d'un film métallique de 100 micromètres de nickel. Elle est retirée de la solution, séchée et présentée uniformément devant la flamme d'un brûleur pendant 30 secondes. Comme dans l'exemple 1 précédent, un fil de cuivre est ensuite brasé sur la couche de nickel puis une force croissante est appliquée sur ce fil jusqu'à arrachement du fil. Celui-ci intervient à 25 MPa.

Sans le traitement thermique de la troisième étape du procédé, le film épais se détache très facilement du substrat d'AlN et tout brasage d'un fil métallique conduit généralement au décollage du film de son support.

## Exemple 3

Une plaque d'AlN est traitée comme dans l'Exemple 2, avec un temps d'immersion de 3 heures et 30 minutes dans la solution électrolytique. Un film de nickel de 250 micromètres est alors réalisé sur la plaque d'AlN. Celle-ci est alors portée uniformément à 400°C pendant 30 secondes. Un test d'arrachement est ensuite réalisé comme précédemment. L'arrachement est obtenu à 15 MPa. La même expérimentation répétée sur d'autres plaques d'AlN traitées de la même façon produit une force d'arrachement distribuée dans la gamme de valeurs comprises entre 12 et 20 MPa.

## Exemple 4

Une plaque est irradiée comme dans l'Exemple 1, puis immergée dans un bain autocatalytique de nickel pendant 15 minutes. Une couche de nickel est alors réalisée. La plaque est alors chauffée à 400°C pendant 15 secondes, puis polarisée et enfin immergée dans une solution électrolytique de nickel pendant 90 minutes. Le test d'arrachement décrit dans les exemples précédents est alors réalisé sur la couche de nickel de 100 micromètres ainsi obtenue. Il donne 30 MPa de force d'arrachement.

Il doit être entendu que l'invention n'est nullement limitée aux formes de réalisation décrites et que bien des modifications peuvent être apportées à ces dernières sans sortir du cadre de la présente invention.

## Revendications

1. Procédé de métallisation de la surface d'une pièce de nitrure d'aluminium (AlN) fritté, au moyen d'une couche métallique d'une épaisseur supérieure à 50 micromètres et adhérente sur cette surface, caractérisé en ce qu'il comprend successivement l'irradiation de la surface de la pièce à métalliser avec le faisceau de lumière émis par un laser excimère d'une longueur d'onde comprise entre 190 et 350 nanomètres et d'une densité d'énergie de 300 à 800 $mJ/cm^2$ pour y former une couche métallique d'aluminium faiblement adhérente, l'immersion de la pièce irradiée dans un bain électro-catalytique sans polarisation dit autocatalytique contenant des ions métalliques pour permettre à ces ions de se déposer sélectivement sur la surface de la pièce recouverte de la couche d'aluminium faiblement adhérente et le traitement à chaud à une température de 400 à 500°C pendant des périodes de temps comprises entre 15 et 30 secondes de la face de la pièce ne contenant pas la couche d'aluminium métallique précitée et en regard de la surface irradiée de façon à obtenir une diffusion de métal dans la pièce d'AlN et à former ainsi la couche métallique adhérente de plus de 50 micromètres.

2. Procédé suivant la revendication 1, caractérisé en ce que le bain autocatalytique contient des ions métalliques choisis dans le groupe comprenant le cuivre, le nickel, le zinc, le fer et le molybdène.

3. Procédé suivant l'une ou l'autre des revendications 1 et 2, caractérisé en ce qu'après l'immersion dans le bain autocatalytique, la pièce est immergée dans un bain électrolytique avec polarisation du même métal ou non que celui déposé par autocatalyse.

4. Procédé suivant l'une ou l'autre des revendications 1 et 2, caractérisé en ce que les ions métalliques déposés par autocatalyse forment une couche d'une épaisseur comprise entre 50 et 250 micromètres.

5. Procédé suivant la revendication 3, caractérisé en ce qu'une couche métallique de 5 micromètres est d'abord déposée par voie autocatalytique, puis une autre couche métallique d'épaisseur comprise entre 50 et 250 micromètres est ensuite déposée par voie électrolytique, les deux couches étant constituées de métaux différents ou identiques.

## Patentansprüche

1. Verfahren zum Metallisieren der Oberfläche eines Sinterkörpers aus Aluminiumnitrid (AlN) mit einer Metallschicht einer Dicke von mehr als 50µm, die an der Oberfläche haftet, **dadurch gekennzeichnet,** daß es umfaßt: sukzessives Bestrahlen der Oberfläche des zu metallisierenden Körpers mit einem Lichtstrahl, der von einem Excimerlaser mit einer Wellenlänge zwischen 190 und 350 Nanometer und einer Energiedichte von 300 bis 800 mJ/cm$^2$ abgestrahlt wird, um auf ihr eine schwach haftende Metallschicht aus Aluminium zu bilden, Eintauchen des bestrahlten Körpers in ein Elektrolytbad ohne Polarisation, das heißt in ein autokatalytisches Bad, welches Metallionen enhält, damit diese Ionen sich selektiv an der Oberfläche des Körpers absetzen können, die von der schwach haftenden Aluminiumschicht bedeckt ist, und Wärmebehandeln der Seite des Körpers, die im Vergleich zu der bestrahlten Oberfläche nicht die vorgenannte metallische Schicht aus Aluminium enthält, bei einer Temperatur von 400 bis 500°C während Zeitspannen zwischen 15 und 30 Sekunden, um dadurch eine Diffusion von Metall in den AlN-Körper hinein zu erreichen und dadurch die mehr als 50µm dicke haftende Metallschicht zu bilden.

2. Verfahren nach Anspruch 1, **dadurch gekennzeichnet,** daß das autokatalytische Bad Ionen eines Metalls enthält, das aus der Gruppe ausgewählt ist, welche Kupfer, Nickel, Zink, Eisen und Molybdän enthält.

3. Verfahren nach einem der Ansprüche 1 und 2, **dadurch gekennzeichnet,** daß nach dem Eintauchen in das autokatalytische Bad der Körper in ein Elektrolytbad mit Polarisation aus dem gleichen oder einem anderen Metall eingetaucht wird, so daß das Metall sich durch Autokatalyse niederschlägt.

4. Verfahren nach einem der Ansprüche 1 und 2, **dadurch gekennzeichnet,** daß die durch Autokatalyse niedergeschlagenen Metallionen eine Schicht mit einer Dicke zwischen 50 und 250µm bildet.

5. Verfahren nach Anspruch 3, **dadurch gekennzeichnet**, daß zunächst auf autokatalytischem Weg eine 5µm betragende Metallschicht niedergeschlagen wird und dann eine weitere Metallschicht mit einer Dicke zwischen 50 und 250µm elektrolytisch niedergeschlagen wird, wobei die beiden Schichten sich aus unterschiedlichen oder gleichen Metallen zusammensetzen.

## Claims

1. Process for metallizing the surface of a sintered aluminium nitride (AlN) part by means of a metallic layer which has a thickness greater than 50 micrometers and adheres to this surface, characterized in that it comprises successively irradiating the surface of the part to be metallized with the light beam emitted by an excimer laser having a wave length comprised between 190 and 350 nanometers and an energy density of 300 to 800 mJ/cm$^2$ so as to form a weakly adhering metallic aluminium layer thereon, immersing the irradiated part in an electrocatalytic bath without polarisation, so-called auto-catalytic, containing metal ions to enable these ions to be deposited selectively onto the surface of the part coated with the weakly adhering aluminium layer and subjecting the side of the part which does not contain said metallic aluminium layer and which is situated opposite the irradiated surface to a heat treatment at a temperature of 400 to 500°C for periods of time comprised between 15 and 30 seconds to achieve a diffusion of metal in the AlN part and to form in this way the adhering metallic layer of more than 50 micrometers.

2. Process according to claim 1, characterized in that the auto-catalytic bath contains metal ions chosen within the group comprising copper, nickel, zinc, iron and molybdenum.

3. Process according to either one of the claims 1 and 2, characterized in that after being immersed in the auto-catalytic bath, the part is immersed in an electrolytic bath with polarisation either of the same metal as the one deposited by auto-catalysis or not.

4. Process according to either one of the claims 1 and 2, characterized in that the metal ions deposited by auto-catalysis form a layer with a thickness comprised between 50 and 250 micrometers.

5. Process according to claim 3, characterized in that a metallic layer of 5 micrometers is first deposited auto-catalytically, subsequently another metallic layer having a thickness comprised between 50 and 250 micrometers is deposited electrolytically, the two layers being formed by the same or different

metals.